# EUROPÄISCHE PATENTANMELDUNG

(11) **EP 1 132 748 A2**
(43) Veröffentlichungstag der Anmeldung: **12.09.2001**
(21) Anmeldenummer: 01105568.8
(22) Anmeldetag: 06.03.2001
(51) Int. Cl.: G01R 31/18, G01R 31/12

(54) **Hochspannungsprüfvorrichtung**

(30) Priorität: 10.03.2000 DE 10011345
(71) Anmelder: ETL Prüftechnik GmbH, 70825 Korntal (DE)
(72) Erfinder: Luithlen, Roland, 70597 Stuttgart (DE); Braunmiller, Mathias, 88097 Eriskirch (DE); Reichardt, Kurt, 71254 Ditzingen (DE)
(74) Vertreter: Patentanwalts-Partnerschaft Rotermund + Pfusch

(57) **Zusammenfassung**

Die Erfindung betrifft eine Vorrichtung (1) zum Durchführen einer Hochspannungsprüfung bei einem elektrischen Gerät (Prüfling), umfassend mindestens eine Kontaktiereinheit (3) mit einer Elektrode (11), an die über ein Hochspannungskabel (9) ein Hochspannungspotential anlegbar ist und die zur Durchführung der Hochspannungsprüfung mit dem Prüfling in Kontakt gebracht wird, und mit einem Schalter (12), an dessen Eingang (13) und Ausgang (14) bei unbetätigtem Schalter (12) über einen mit einer Steuerung (4) verbundenen Signalkreis eine Niederspannungspotentialdifferenz anliegt und der bei Betätigung die Erzeugung eines elektrischen Signals bewirkt, das einen Kontakt zwischen Elektrode (11) und Prüfling signalisiert und über den Signalkreis der Steuerung (4) zugeleitet wird, wobei die Steuerung (4) so ausgebildet ist, daß eine Prüfprozedur erst dann beginnt, wenn der Schalter (12) betätigt ist.

Um eine derartige Vorrichtung hinsichtlich ihrer Zuverlässigkeit zu verbessern, wird vorgeschlagen, daß beide Kontaktiereinheiten (3) mit einem solchen Schalter (12) ausgestattet sind, wobei die Steuerung (4) so ausgebildet ist, daß eine Prüfprozedur erst dann beginnt, wenn beide Schalter (12) betätigt sind.

## Beschreibung

Die Erfindung betrifft eine Vorrichtung zum Durchführen einer Hochspannungsprüfung bei einem elektrischen Gerät, dem sogenannten "Prüfling", mit den Merkmalen des Oberbegriffs des Anspruchs 1.

Aus dem Firmenprospekt "TECHNOLOGY IN ADVANCE" der Firma Schleich GmbH in D-58675 Hemer, Seiten 1 und 27 ist eine solche Vorrichtung bekannt, die zwei als Prüfpistole ausgebildete Kontaktiereinheiten aufweist. Die Prüfpistolen enthalten jeweils eine Elektrode, an die über ein Hochspannungskabel ein Hochspannungspotential anlegbar ist und die zur Durchführung der Hochspannungsprüfung mit dem Prüfling in Kontakt gebracht wird. In eine der Prüfpistolen ist ein Schalter integriert, der manuell mit dem Abzug der Prüfpistole betätigt wird. Solange der Schalter unbetätigt ist, liegt am Schalter bzw. an dessen Eingang und Ausgang eine Niederspannungspotentialdifferenz von ca. 5 Volt an. Eingang und Ausgang des Schalters sind dazu mit zwei separaten Signalkabeln eines Signalkreises mit einer Steuerung verbunden, die den Signalkreis auswertet. Bei einer Betätigung des Schalters wird ein elektrisches Signal erzeugt, das einen Kontakt zwischen Elektrode und Prüfling signalisiert und über den Signalkreis der Steuerung zugeleitet wird. Die Steuerung ist dabei so ausgebildet, daß eine Prüfprozedur erst dann beginnt, wenn der Schalter betätigt ist.

Das durch die Betätigung des Schalters ausgelöste Signal wird bei einer derartigen Vorrichtung benötigt, um gewährleisten zu können, daß eine vorgegebene Prüfprozedur erst dann beginnt, wenn der Prüfer, der die Prüfpistolen handhabt, der Ansicht ist, daß die Elektroden mit dem Prüfling in Kontakt stehen. Bei der bekannten Vorrichtung befinden sich die zum Schalter führenden Signalkabel des Signalkreises auf einem Niederspannungsniveau, um ein entsprechendes Schaltsignal beim Betätigen des Schalters zu erzeugen. Da die Potentialdifferenz am Eingang und Ausgang des Schalters im Bereich eines niedrigen Spannungswertes gewählt ist, kann ein relativ preiswerter Schalter verwendet werden, außerdem eignet sich das damit erzeugbare Signal besonders zur Verarbeitung in der Steuerung. Die beiden Signalkabel des Signalkreises und das Hochspannungskabel sind in einem gemeinsamen Kabelmantel untergebracht, um die Handhabung der zugehörigen Prüfpistole zu vereinfachen.

Die vorliegende Erfindung beschäftigt sich mit dem Problem, für eine Vorrichtung der eingangs genannten Art eine Ausführungsform anzugeben, die mit einer erhöhten Zuverlässigkeit arbeitet.

Dieses Problem wird erfindungsgemäß durch eine Vorrichtung mit den Merkmalen des Anspruchs 1 gelöst.

Die Erfindung beruht auf dem allgemeinen Gedanken, mehrere Kontaktiereinheiten jeweils mit einem Schalter auszustatten und die Steuerung mit einer UND-Verknüpfung zu versehen, derart, daß eine Prüfprozedur erst dann beginnen kann, wenn alle Schalter der Kontaktiereinheiten betätigt sind. Durch diese Maßnahme wird gewährleistet, daß eine Hochspannungsprüfung tatsächlich nur dann beginnt, wenn die Elektroden der mit den Schaltern versehenen Kontaktiereinheiten mit dem Prüfling in Kontakt stehen. Bei einer automatisch arbeitenden Prüfanlage, bei der die einzelnen Kontaktiereinheiten simultan oder nacheinander mit dem Prüfling in Kontakt kommen, führt dies zu einer Vereinfachung, da es nun nicht mehr auf Synchronität oder auf die Reihenfolge ankommt, wie die einzelnen Kontaktiereinheiten mit dem Prüfling in Kontakt kommen.

Bei manuell durchgeführten Hochspannungsprüfungen, bei denen ein Prüfer mit jeder Hand eine Kontaktiereinheit bedient, ergibt sich ebenfalls eine Verbesserung hinsichtlich der Zuverlässigkeit der Hochspannungsprüfung. Da die Prüfprozedur erst dann beginnt, wenn auch der zweite Schalter betätigt ist, ohne daß es dabei auf die Reihenfolge der Kontaktierung bzw. der Schalterbetätigung ankommt, muß auch der Prüfer nicht mehr auf eine bestimmte Reihenfolge bei der Kontaktierung der Kontaktiereinheiten mit dem Prüfling achten.

Ein wichtiger Vorteil ist auch darin zu sehen, daß durch die Erfindung die exakte Protokolierbarkeit der Prüfprozedur verbessert wird, was sich positiv auf die Qualitätssicherung auswirkt.

Entsprechend einer bevorzugten Ausführungsform kann die Elektrode in der jeweiligen Kontaktiereinheit bidirektional verstellbar gelagert sein und so mit dem zugehörigen Schalter zusammenwirken, daß die Elektrode sich beim Kontakt mit dem Prüfling verstellt und dadurch den Schalter betätigt. Während es bei einem herkömmlichen, durch den Abzug der als Pistole ausgebildeten Kontaktiereinheit betätigten Schalter auf das Geschick des Prüfers ankommt, der daher subjektiv entscheidet, ob ein Kontakt zwischen Elektrode und Prüfling vorliegt oder nicht, gewährleistet die vorgeschlagene Variante, daß nur dann der Schalter betätigt wird, wenn tatsächlich die Elektrode mit dem Prüfling in Kontakt steht. Die Meßsicherheit und Zuverlässigkeit der dadurch erzielten Prüfergebnisse wird dementsprechend verbessert. Ein besonders anwenderfreundliches Handling ergibt sich dann, wenn die Kontaktiereinheiten jeweils als manuell betätigbare Prüfpistolen ausgebildet sind.

Entsprechend einer besonderen Weiterbildung können sich Eingang und Ausgang des Schalters zumindest bei am Hochspannungskabel anliegenden Hochspannungspotential etwa auf demselben Potentialniveau befinden wie das Hochspannungskabel. Diese Weiterbildung beruht auf dem allgemeinen Gedanken, den Signalkreis und das Hochspannungskabel auf demselben oder annähernd demselben Potential zu betreiben. Durch diese Maßnahme besteht zwischen dem Signalkreis und dem Hochspannungskabel keine große Potentialdifferenz, so daß Ableitströme durch die Kapazität zwischen dem Hochspannungskabel und dem Signalkreis reduziert werden. Dementsprechend verringert sich auch der negative Einfluß derartiger Ableitströme auf das Prüfungsergebnis und die Sicherheit der Vorrichtung. Bei einer herkömmlichen Vorrichtung ist die Kabellänge begrenzt, da die Größe des sich ausbildenden Ableitstromes von der Kabellänge abhängt. Bei der vorgeschlagenen Weiterbildung reduziert sich diese Begrenzung der Kabellänge dementsprechend, so daß erheblich längere Kabel ausgebildet werden können. Darüber hinaus ist es durch diese Maßnahmen aufgrund der geringen Potentialdifferenz zwischen den Signalkabel und Hochspannungskabel nunmehr ohne weiteres möglich, einen sicheren mehrpoligen Stecker zu konstruieren, mit dem sowohl das Hochspannungskabel als auch die Signalkabel des Signalkreises gleichzeitig an die Vorrichtung angeschlossen werden können. Dementsprechend ist es nun möglich, einen gemeinsamen Stecker für das Hochspannungskabel und den Signalkreis zu konstruieren, so daß sich auch hier eine Vereinfachung ergibt.

Entsprechend einer bevorzugten Ausführungsform kann die Steuerung der Vorrichtung so ausgebildet sein, daß sich Eingang und Ausgang des Schalters auf einem Niederspannungsniveau befinden, wenn das Hochspannungspotential nicht am Hochspannungskabel anliegt. Dementsprechend herrscht auch vor und nach der Hochspannungsprüfung, das heißt, solange keine Hochspannung am Hochspannungskabel anliegt, eine relativ kleine Spannungsdifferenz zwischen dem Signalkreis und dem Hochspannungskabel. Es ist klar, daß die Steuerung das Potentialniveau am Schalter bzw. am Eingang und Ausgang des Schalters dann in Abhängigkeit des durch Betätigen des Schalters erzeugten Signalwertes umschaltet und zwar auf Hochspannungsniveau, wenn der Schalter betätigt wird und die Hochspannung an das Hochspannungskabel angelegt wird, bzw. auf Niederspannungsniveau, wenn der Schalter nicht betätigt ist und dementsprechend die Hochspannung nicht am Hochspannungskabel anliegt.

Gemäß einer besonders vorteilhaften Ausführungsform weist der Signalkreis zwei Signalleitungen auf, zwischen denen bei unbetätigtem Schalter die Niederspannungspotentialdifferenz herrscht, wobei die eine Signalleitung durch ein Signalkabel gebildet ist und wobei die andere Signalleitung durch das Hochspannungskabel gebildet ist. Bei dieser Variante wird zweckmäßig für eine Signalleitung des Signalkreises das Hochspannungskabel verwendet, wodurch ein zweites Signalkabel entfallen kann. Dementsprechend kann auch der Anschluß an die Vorrichtung mittels eines entsprechenden Steckers vereinfacht werden.

Weitere wichtige Merkmale und Vorteile der erfindungsgemäßen Vorrichtung ergeben sich aus den Unteransprüchen, aus den Zeichnungen und aus der zugehörigen Figurenbeschreibung anhand der Zeichnungen.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert.

Es zeigen, jeweils schematisch,
- Fig. 1: eine schaltplanartige Prinzipdarstellung einer erfindungsgemäßen Vorrichtung,
- Fig. 2: eine Ansicht wie in Fig. 1, jedoch einer anderen Ausführungsform, und
- Fig. 3: eine Prinzipdarstellung einer Kontaktiereinheit, die als Prüfpistole ausgebildet ist.

Unter Hochspannung wird im vorliegenden Zusammenhang insbesondere eine Spannung von mindestens 1.000 Volt verstanden, während eine Niederspannung regelmäßig weniger als 48 Volt, vorzugsweise etwa 5 Volt beträgt.

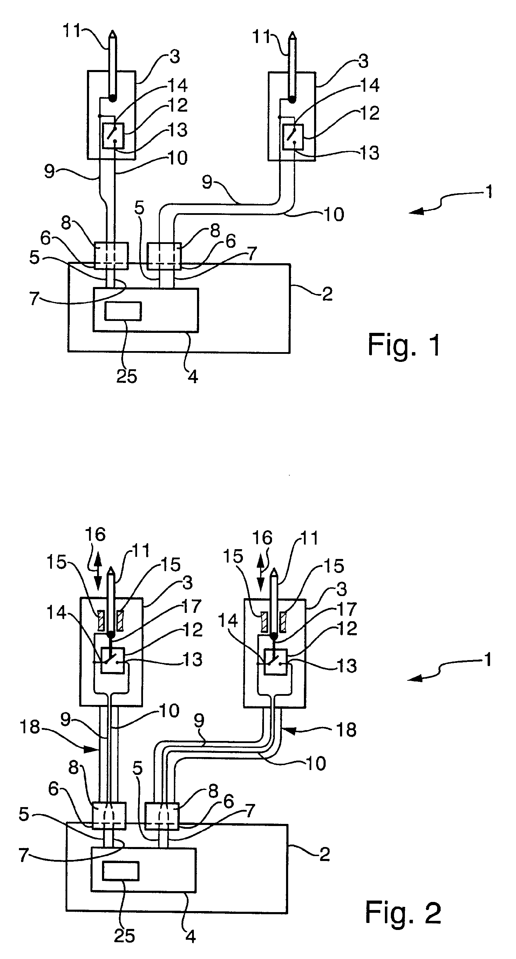

Entsprechend den Fig. 1 und 2 weist eine erfindungsgemäße Vorrichtung 1 ein Basisgerät 2 und wenigstens zwei Kontaktiereinheiten 3 auf, die grundsätzlich identisch oder verschieden aufgebaut sein können. Es ist klar, daß die Vorrichtung 1 auch drei oder mehr Kontaktiereinheiten 3 aufweisen kann.

Das stark vereinfacht dargestellte Basisgerät 2 enthält zumindest eine Steuerung 4, die mit jeder Kontaktiereinheit 3 jeweils über eine erste Verbindungsleitung 5 mit einem entsprechenden Kontakt einer Steckdose 6 verbunden ist. Mit einer zweiten Verbindungsleitung 7 ist die Steuerung 4 mit einem entsprechenden anderen Kontakt der Steckdose 6 verbunden. In die Steckdose 6 ist ein Stecker 8 eingesteckt, der gemeinsam am Ende eines Hochspannungskabels 9 und eines Signalkabels 10 ausgebildet ist.

Im Inneren der Kontaktiereinheit 3 ist das Hochspannungskabel 9 an eine Elektrode 11 angeschlossen, die an ein nicht dargestelltes elektrisches Gerät zur Anlage gebracht wird, wenn dieses als "Prüfling" bezeichnete elektrische Gerät z.B. hinsichtlich seiner elektrischen Isolierung geprüft werden soll. Die Kontaktiereinheit 3 weist außerdem einen Schalter 12 auf, dessen Eingang 13 mit dem Signalkabel 10 verbunden ist und dessen Ausgang 14 mit dem Hochspannungskabel 9 verbunden ist. Es ist klar, daß die Bezeichnungen "Eingang" und "Ausgang" hier austauschbar sind.

Bei der speziellen Ausführungsform gemäß Fig. 2 ist die Elektrode 11 in der Kontaktiereinheit 3 bidirektional verstellbar gelagert, wobei sich die Elektrode 11 parallel zu ihrer Längsachse verstellt. Eine entsprechende Lagerung ist nur symbolisch dargestellt und mit 15 bezeichnet. Die bidirektionale Längsverstellbarkeit der Elektrode 11 ist jeweils durch einen Doppelpfeil 16 symbolisiert.

Die Elektrode 11 ist mit dem Schalter 12 über eine Kopplung 17 verbunden, wodurch die Elektrode 11 zur Betätigung des Schalters 12 mit diesem zusammenwirken kann. Wenn sich die Elektrode 11 in die Kontaktiereinheit 3 hineinverstellt, betätigt sie über die Kopplung 17 den Schalter 12, wodurch Eingang 13 und Ausgang 14 des Schalters 12 miteinander verbunden werden.

Bei der in Fig. 2 wiedergegebenen Ausführungsform sind das Hochspannungskabel 9 und das Signalkabel 10 in einem gemeinsamen Kabelmantel 18 zusammengefaßt, wodurch sich das Handling der Hochspannungsprüfvorrichtung 1 vereinfacht.

Die Steuerung 4 enthält eine elektronische Schaltung mit einer UND-Verknüpfung 25, mit der die Signale beider Schalter 12 verarbeitet werden. Eine UND-Verschaltung ist allgemein bekannt und wird daher nicht näher erläutert.

Die erfindungsgemäße Vorrichtung 1 arbeitet wie folgt:

Solange keine Hochspannungsprüfung stattfindet, bewirkt die Steuerung 4, daß einerseits am Hochspannungskabel 9 keine Hochspannung anliegt und daß andererseits zwischen dem Hochspannungskabel 9 und dem Signalkabel 10 eine Niederspannungspotentialdifferenz besteht. Diese Potentialdifferenz kann z.B. 5 Volt betragen. Beispielsweise liegen am Hochspannungskabel 5 Volt und am Signalkabel 0 Volt an.

Die Kontaktiereinheiten 3 können beispielsweise in einer automatisch arbeitenden Prüfanlage zum Einsatz kommen und dementsprechend selbsttätig gegen einen Prüfling, z.B. ein Bügeleisen, gefahren werden, damit die Elektroden 11 jeweils mit einem zu überprüfenden Bestandteil des Prüflings in Kontakt kommen. Beispielsweise soll die elektrische Isolation eines Gehäuses des Prüflings an zwei Stellen gleichzeitig überprüft werden. Wenn die selbsttätig arbeitende Prüfanlage davon ausgeht, daß die jeweilige Elektrode 11 in Kontakt mit dem Prüfling steht, wird der zugehörige Schalter 12 betätigt, so daß Eingang 13 und Ausgang 14 miteinander verbunden sind. Auf diese Weise wird für jeden Kontakt ein elektrisches Signal erzeugt, das über das Signalkabel 10 bzw. über das Hochspannungskabel 9 an die Steuerung 4 weitergeleitet wird und von dieser ausgewertet werden kann. Sobald die Steuerung 4 das durch den geschlossenen Schalter 12 verursachte Signal empfängt, geht die Steuerung 4 davon aus, daß ein Kontakt zwischen der zugehörigen Elektrode 11 und dem Prüfling besteht. Die Steuerung 4 wertet die Signale der Schalter 12 beider Kontaktiereinheiten 3 mittels der UND-Verknüpfung 25 aus und startet die Prüfprozedur erst dann, wenn beide Schalter 12 betätigt sind, also wenn beide Elektroden 11 mit dem Prüfling in Kontakt stehen. Auf die Reihenfolge der Kontaktierung kommt es dabei nicht an. Das Signal für den Kontakt zwischen Elektrode 11 und Prüfling ist für eine ordnungsgemäße Hochspannungsprüfung von besonderer Bedeutung, da die Hochspannungsprüfung, die beispielsweise verschiedene Spannungen und verschiedene Zeitabläufe beinhaltet, genau dokumentiert werden muß.

Während der Hochspannungsprüfung bewirkt die Steuerung 4, daß am Hochspannungskabel 9 die Prüfspannung mit Hochspannungspotential anliegt. Gleichzeitig bewirkt die Steuerung 4, daß auch das Signalkabel 10 auf einem Hochspannungspotential liegt, das etwa gleich groß ist, wie das Potential des Hochspannungskabels 9. Die Steuerung 4 ist so ausgebildet, daß stets etwa dieselbe niedrige Potentialdifferenz zwischen dem Hochspannungskabel 9 und dem Signalkabel 10 vorliegt. Wenn beispielsweise am Hochspannungskabel 9 1.000 Volt anliegen, wird das Signalkabel 9 mit 995 Volt beaufschlagt, so daß die Potentialdifferenz auch hier wieder etwa 5 Volt beträgt. Entsprechendes gilt für andere Hochspannungswerte, die im Rahmen der Hochspannungsprüfung durchlaufen werden können. Auf diese Weise kann gewährleistet werden, daß nur minimale Ableitströme aufgrund kapazitiver Effekte zwischen den Kabeln 9 und 10 auftreten, wodurch die Hochspannungsprüfung eine besonders hohe Genauigkeit und Zuverlässigkeit aufweist.

Wenn die Hochspannungsprüfung beendet ist, werden die Schalter 12 wieder geöffnet, was von der Steuerung 4 erkannt wird, so daß diese die Hochspannungspotentiale am jeweiligen Hochspannungskabel 9 und am jeweiligen Signalkabel 10 wieder auf Niederspannungspotentiale reduziert.

Während bei der Ausführungsform gemäß Fig. 1 die Schalter 12 manuell oder im Rahmen einer automatischen Prüfanlage programmgesteuert betätigt werden, erfolgt die Betätigung der Schalters 12 bei der Variante gemäß Fig. 2 selbsttätig dann, wenn die jeweilige Elektrode 11 durch ihren Kontakt mit dem Prüfling hinreichend in die Kontaktiereinheit 3 hineinverstellt wird.

Die Elektrode 11 ist dabei vorzugsweise mittels nicht dargestellter Federmittel nach außen vorgespannt, so daß der Schalter 12 beim Entfernen der Kontaktiereinheit 3 vom Prüfling selbsttätig wieder geöffnet wird.

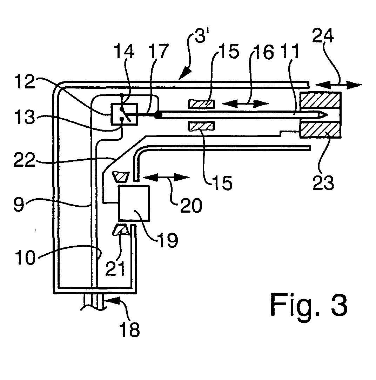

Entsprechend einer besonders vorteilhaften Ausführungsform kann die Kontaktiereinheit 3' entsprechend Fig. 3 als manuell betätigbare Prüfpistole ausgebildet sein. Die Prüfpistole oder Kontaktiereinheit 3' weist hier ebenfalls eine Lagerung 15 für eine bidirektionale Verstellbarkeit der Elektrode 11 auf. Dementsprechend ist auch hier die Elektrode 11 über die Kopplung 17 mit dem Schalter 12 verbunden, um diesen durch bidirektionale Verstellungen betätigen zu können.

Die pistolenförmige Kontaktiereinheit 3' weist einen Abzug 19 auf, der entsprechend einem Doppelpfeil 20 in der Kontaktiereinheit 3' verstellbar gelagert ist. Entsprechende Lager sind bei 21 angedeutet. Anstelle einer linearen Verstellbarkeit kann der Abzug 19 auch schwenkverstellbar an der Kontaktiereinheit 3' gelagert sein. Der Abzug 19 ist über eine nur symbolisch dargestellte Kopplung 22 mit einem Schutzrohr 23 antriebsverbunden, derart, daß eine Betätigung des Auslösers 19 das Schutzrohr 23 aus der in Fig. 3 dargestellten Sicherungsposition in eine Entsicherungsposition verstellt.

Das Schutzrohr 23 umgibt die Elektrode 11 in ihrem vorderen Endbereich. In seiner Sicherungsposition überragt das Schutzrohr 23 das vordere Ende der Elektrode 11, so daß kein direkter Kontakt mit der Elektrode 11 möglich ist. In der eingefahrenen Entsicherungsposition ragt die Elektrodenspitze über das Schutzrohr 23 vor, wodurch ein direkter Kontakt mit der Elektrode 11 ermöglicht wird. Die Verstellbarkeit des Schutzrohres 23 ist durch einen Doppelpfeil 24 symbolisch dargestellt. Auch hier sind vorzugsweise nicht dargestellte Federmittel vorgesehen, die das Schutzrohr 23 in seine Sicherungsposition vorspannen.

Bei einer Vorrichtung 2, die mit mindestens zwei Prüfpistolen 3' ausgestattet ist, deren Elektroden 11 von einem oder zwei Prüfern manuell mit dem Prüfling in Kontakt gebracht werden sollen, wirkt sich die bei der Erfindung vorgesehene UND-Verknüpfung 25 besonders vorteilhaft aus, da die Prüfprozedur erst dann gestartet wird, wenn die Elektroden 11 aller Prüfpistolen 3' objektiv kontaktiert sind. Die Vorrichtung 1 arbeitet demnach unabhängig von der subjektiven Meinung des jeweiligen Prüfers.

## Patentansprüche

1. Vorrichtung zum Durchführen einer Hochspannungsprüfung bei einem elektrischen Gerät (Prüfling), mit mindestens zwei Kontaktiereinheiten (3), die jeweils eine Elektrode (11) aufweisen, an die über ein Hochspannungskabel (9) ein Hochspannungspotential anlegbar ist und die zur Durchführung der Hochspannungsprüfung mit dem Prüfling in Kontakt gebracht wird, wobei wenigstens eine der Kontaktiereinheiten (3) einen Schalter (12) aufweist, an dessen Eingang (13) und Ausgang (14) bei unbetätigtem Schalter (12) über einen mit einer Steuerung (4) verbundenen Signalkreis eine Niederspannungspotentialdifferenz anliegt und der bei Betätigung die Erzeugung eines elektrischen Signals bewirkt, das einen Kontakt zwischen Elektrode (11) und Prüfling signalisiert und über den Signalkreis der Steuerung (4) zugeleitet wird, wobei die Steuerung (4) so ausgebildet ist, daß eine Prüfprozedur erst dann beginnt, wenn der Schalter (12) betätigt ist,
**dadurch gekennzeichnet,**
daß beide Kontaktiereinheiten (3) mit einem solchen Schalter (12) ausgestattet sind und daß die Steuerung (4) so ausgebildet ist, daß die Prüfprozedur erst dann beginnt, wenn beide Schalter (12) betätigt sind.

2. Vorrichtung nach Anspruch 1,
**dadurch gekennzeichnet,**
daß die Steuerung (4) eine UND-Verknüpfung (25) aufweist.

3. Vorrichtung nach Anspruch 1 oder 2,
**dadurch gekennzeichnet,**
daß die Elektrode (11) in der Kontaktiereinheit (3) bidirektional verstellbar gelagert ist und so mit dem Schalter (12) zusammenwirkt, daß die Elektrode (11) sich beim Kontakt mit dem Prüfling verstellt und dadurch den Schalter (12) betätigt.

4. Vorrichtung nach einem der Ansprüche 1 bis 3,
**dadurch gekennzeichnet,**
daß die Kontaktiereinheit (3') als manuell betätigbare Prüfpistole ausgebildet ist.

5. Vorrichtung nach einem der Ansprüche 1 bis 4,
**dadurch gekennzeichnet,**
daß sich Eingang (12) und Ausgang (14) des Schalters (12) zumindest bei am Hochspannungskabel (9) anliegenden Hochspannungspotential etwa auf demselben Potentialniveau befinden wie das Hochspannungskabel (9).

6. Vorrichtung nach einem der vorhergehenden Ansprüche,
**dadurch gekennzeichnet,**
daß die Steuerung (4) so ausgebildet ist, daß sich Eingang (13) und Ausgang (14) des Schalters (12) auf einem Niederspannungsniveau befinden, wenn das Hochspannungspotential nicht am Hochspannungskabel (9) anliegt.

7. Vorrichtung nach einem der vorhergehenden Ansprüche,
**dadurch gekennzeichnet,**
daß der Signalkreis zwei Signalleitungen aufweist, zwischen denen bei unbetätigtem Schalter (12) die Niederspannungspotentialdifferenz herrscht, wobei die eine Signalleitung durch ein Signalkabel (10) gebildet ist und wobei die andere Signalleitung durch das Hochspannungskabel (9) gebildet ist.

8. Vorrichtung nach Anspruch 7,
**dadurch gekennzeichnet,**
daß das Signalkabel (10) und das Hochspannungskabel (9) in einem gemeinsamen Kabelmantel (18) untergebracht sind.

9. Vorrichtung nach Anspruch 7 oder 8,
**dadurch gekennzeichnet,**
daß das Signalkabel (10) und das Hochspannungskabel (9) einen gemeinsamen Stecker (8) aufweisen.
